# EUROPÄISCHE PATENTSCHRIFT

(11) **EP 3 417 548 B1**
(45) Veröffentlichungstag und Bekanntmachung des Hinweises auf die Patenterteilung: **10.06.2020**
(21) Anmeldenummer: 17706439.1
(22) Anmeldetag: 17.02.2017
(51) Int. Cl.: H04B 3/32, H04L 25/02, H04B 3/487, G01R 19/165, G06F 13/00, G06F 13/40, H04L 12/40

(54) **VERFAHREN ZUR ERHÖHUNG DES STÖRABSTANDS BEI GLEICHTAKTSTÖRUNGEN AUF EINEM ZWEIDRAHTDATENBUS**
METHOD FOR INCREASING THE SIGNAL-TO-NOISE RATIO FOR COMMON-MODE INTERFERENCE ON A TWO-WIRE DATA BUS
PROCÉDÉ D'AUGMENTATION DU RAPPORT SIGNAL/BRUIT LORS DE BRUITAGES EN MODE COMMUN SUR UN BUS DE DONNÉES BIFILAIRE

(30) Priorität: 18.02.2016 DE 102016102813; 18.02.2016 DE 102016102815; 18.02.2016 DE 102016102814; 18.02.2016 DE 102016102816; 22.11.2016 DE 102016122450; 22.11.2016 DE 102016122449; 22.11.2016 DE 102016122452; 22.11.2016 DE 102016122451
(43) Veröffentlichungstag der Anmeldung: 26.12.2018
(73) Patentinhaber: Elmos Semiconductor Aktiengesellschaft, 44227 Dortmund (DE)
(72) Erfinder: GÖTZ, Marco, 01445 Radebeul (DE)
(74) Vertreter: dompatent von Kreisler Selting Werner - Partnerschaft von Patent- und Rechtsanwälten mbB
(86) Internationale Anmeldenummer: PCT/EP2017/053681
(87) Internationale Veröffentlichungsnummer: WO 2017/140884

(56) Entgegenhaltungen:
- EP-A2- 2 282 406
- US-B1- 8 891 595

## Beschreibung

Die Erfindung betrifft Vorrichtungen und Verfahren zur Erhöhung des Störabstands bei Gleichtaktstörungen auf einem Zweidrahtdatenbus.

Bei der digitalen Übertragung von Daten in Zweidrahtbussen ist es ein permanentes Problem, dass auf den beiden Datenbusleitungen einer Zweidrahtdatenbusleitung durch Einstrahlung von außen ein Gleichtakthub erzeugt wird, der zu einer Verzerrung des Eingangssignals und damit zu einer Verfälschung empfangener Daten führen kann, wenn die Eingangsstufen durch diesen Gleichtakthub in Sättigung geraten. Ganz besonders kritisch ist diese Situation bei automobilen Datenbussen, wie beispielsweise dem Flexray-Datenbus.

Aus DE-A-10 2014 204 048 ist eine Teilnehmerstation für ein Bussystem bekannt, die ein Emissionssteuersystem zur Steuerung der Eigenschaften der Sende/Empfangseinrichtung zur Reduktion von leitungsgebundenen Emissionen in dem jeweiligen Bussystem aufweist. Der Gegenstand dieser Schrift betrifft somit lediglich Emissionen des Bussystems nach außen, nicht jedoch eine Steigerung der Robustheit in die umgekehrte Richtung, d.h. gegenüber Einstrahlungen von außen.

Aus DE-A-10 2009 000 697 ist eine Treiberschaltung für eine Zweidrahtleitung bekannt, die die Spannungen auf der Zweidrahtleitung auswertet und ggf. beim Auftreten fehlerhafter Zustände ein Fehlersignal setzt. Ggf. wird der Ausgangsstrom der Treiberschaltung nachgeregelt.

Aus US-A-5 825 819 ist ein Treiber bekannt, der über eine Gleichtaktunterdrückung mittels einer Rückkopplungsschleife verfügt. Diese ist jedoch auch während des Normalbetriebs permanent wirksam und beeinflusst somit den Normalbetrieb. Ziel ist es aber auch, Ereignisse, die das System in einen nicht spezifikationskonformen Zustand bringen, beherrschen zu können, ohne den Normalbetrieb durch eine solche Gegentaktunterdrückung nicht-spezifikationskonform zu beeinträchtigen.

Aus der US-A-2003/0 085 736 ist eine weitere Gegentaktunterdrückung bekannt, die auch während des Normalbetriebs aktiv ist.

Aus US-A-5 592 510 ist ein Treiber für eine Twisted-Pair-Leitung bekannt, der den Gleichtaktstrom in einer Zweidrahtdatenbusleitung aktiv vermindert. Auch diese Gleichtaktunterdrückung ist während des Normalbetriebs aktiv.

Im Stand der Technik belasten diese Gleichtaktunterdrückungen die Sende- und Empfangsvorrichtungen im ungestörten Normalbetrieb. Tritt eine nicht spezifikationskonforme Störung auf, so soll sich ein Übertragungssystem möglichst robust gegen solche Störungen - die an sich ja selbst die Spezifikation verletzen - verhalten. Eine Gleichtaktunterdrückung für derartig außergewöhnliche Ereignisse darf aber den Normalbetrieb bei diesbezüglich empfindlichen Bussystemen, wie beispielsweise Flexray, nicht übermäßig einschränken.

Aus US-B-8 891 595 ist ein Verfahren gemäß dem Oberbegriff des Anspruchs 1 bekannt, während EP-A- 2 282 406 ein Verfahren gemäß Anspruch 2 beschreibt.

Es ist die Aufgabe der Erfindung, eine kritische Gleichtaktstörung zu erkennen und durch zusätzliche vorzugsweise gleichzeitig zu ergreifende, jedoch nicht zwingend synchrone Maßnahmen den Störabstand für die Datenübertragung zu erhöhen.

Zur Lösung dieser Aufgabe schlägt die Erfindung ein Verfahren vor, das die Merkmale des Anspruchs 1 oder des Anspruchs 2 oder des Anspruchs 3 oder des Anspruchs 4 oder des Anspruchs 5 aufweist.

Die Erfindung gemäß den nachfolgend aufgeführten Varianten beruht auf dem gemeinsamen Konzept, bei einer Gleichtaktstörung des Zweidrahtdatenbusses entweder senderseitig den (differentiellen) Signalpegel zu erhöhen oder empfängerseitig die Empfindlichkeit gegenüber Gleichtaktstörungen zu verringern oder beides zu veranlassen.

Gemäß einer ersten Variante wird diese Aufgabe erfindungsgemäß gelöst durch ein Verfahren, bei dem die Detektion eines zu großen Gleichtaktspannungshubes durch den Sender erfolgt, nämlich durch ein Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
   i) wobei der erste Treiber (D1) die erste Datenleitung (d1) mit einem ersten Offset (O1) und einem ersten Spannungspegel (P1) treibt,
   ii) wobei der zweite Treiber (D2) die zweite Datenleitung (d2) mit einem zweiten Offset (O2) und einem zweiten Spannungspegel (P2) treibt und
   iii) wobei der differentielle Sendepegel die Differenz aus dem ersten Spannungspegel (P1) und dem zweiten Spannungspegel (P2) ist,
c) Empfangen der Daten durch den Empfänger (E) mittels Erfassung der Spannungsdifferenzen zwischen dem dritten Anschluss (A3) und dem vierten Anschluss (A4) des Empfängers (E) und
d) Vergleichen des Betrags des erfassten ersten Gleichtaktspannungshubes mit einem ersten Schwellwert (SW1) und (insbesondere senderseitiges) Anheben des differentiellen Sendepegels, wenn der Betrag des ersten Gleichtaktspannungshubes größer ist als der erste Schwellwert (SW1) .

Gemäß einer zweiten Variante wird die Aufgabe erfindungsgemäß gelöst durch ein Verfahren, bei dem die Detektion eines zu großen Gleichtaktspannungshubes durch den Empfänger erfolgt, der einen Komparator zum Vergleich des Gleichtakthubes mit einem Schwellwert aufweist, d.h. durch ein Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) zur Erzeugung von Spannungsdifferenzen (über der Zeit) zwischen diesen,
c) Empfangen der Daten durch den Empfänger (E) mittels Erfassung der Spannungsdifferenzen zwischen dem dritten Anschluss (A3) und dem vierten Anschluss (A4) des Empfängers (E),
d) Vergleichen der zwischen dem dritten und dem vierten Anschluss (A3,A4) des Empfängers (E) gegebenen Spannungsdifferenzen mit einem dritten Schwellwert (SW3), wobei Spannungsdifferenzen oberhalb dieses dritten Schwellwerts (SW3) ein erster logischer Wert zugeordnet wird und Spannungsdifferenzen unterhalb dieses dritten Schwellwerts (SW3) ein zum ersten logischen Wert invertierter zweiter logischer Wert zugeordnet wird, und
e) Vergleichen des Betrags des erfassten zweiten Gleichtaktspannungshubes mit einem zweiten Schwellwert (SW2) und (insbesondere empfängerseitiges) Anheben des dritten Schwellwerts (SW3), wenn der Betrag des zweiten Gleichtaktspannungshubes größer ist als der zweite Schwellwert (SW2).

Gemäß einer dritten Variante wird die Aufgabe erfindungsgemäß gelöst durch ein Verfahren, bei dem die Detektion eines zu großen Gleichtaktspannungshubes durch sowohl den Sender als auch den Empfänger, der einen Komparator zum Vergleich des Gleichtaktspannungshubes aufweist, erfolgt, nämlich durch ein Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
c) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
   i) wobei der erste Treiber (D1) die erste Datenleitung (d1) mit einem ersten Offset (O1) und einem ersten Spannungspegel (P1) treibt,
   ii) wobei der zweite Treiber (D2) die zweite Datenleitung (d2) mit einem zweiten Offset (O2) und einem zweiten Spannungspegel (P2) treibt und
   iii) wobei der differentielle Sendepegel die Differenz aus dem ersten Spannungspegel (P1) und dem zweiten Spannungspegel (P2) ist,
d) Empfangen der Daten durch den Empfänger (E) mittels Erfassung der Spannungsdifferenzen zwischen dem dritten Anschluss (A3) und dem vierten Anschluss (A4) des Empfängers (E),
e) Vergleichen der zwischen dem dritten und dem vierten Anschluss (A3,A4) des Empfängers (E) gegebenen Spannungsdifferenzen mit einem dritten Schwellwert (SW3), wobei Spannungsdifferenzen oberhalb dieses dritten Schwellwerts (SW3) ein erster logischer Wert zugeordnet wird und Spannungsdifferenzen unterhalb dieses dritten Schwellwerts (SW3) ein zum ersten logischen Wert invertierter zweiter logischer Wert zugeordnet wird,
f) Vergleichen des Betrags des erfassten ersten Gleichtaktspannungshubes mit einem ersten Schwellwert (SW1) und (insbesondere senderseitiges) Anheben des differentiellen Sendepegels, wenn der Betrag des ersten Gleichtaktspannungshubes größer ist als der erste Schwellwert (SW1),
g) Vergleichen des Betrags des erfassten zweiten Gleichtaktspannungshubes mit einem zweiten Schwellwert (SW2) und (insbesondere empfängerseitiges) Anheben des dritten Schwellwerts (SW3), wenn der Betrag des zweiten Gleichtaktspannungshubes größer ist als der zweite Schwellwert (SW2), und
h) Übertragen eines Datums vom Sender (S) zum Empfänger (E), das von dem Ergebnis des Vergleichs des Betrags des erfassten ersten Gleichtaktspannungshubes mit dem ersten Schwellwert (SW1) abhängt (d.h. das qualitativ repräsentiert, ob der Betrag des erfassten ersten Gleichtaktspannungshubes größer oder kleiner ist als der erste Schwellwert (oder gleich dem ersten Schwellwert) ist, oder dass zusätzlich noch quantitativ die Größe zwischen beiden repräsentiert), und (insbesondere empfängerseitiges) Anheben des dritten Schwellwerts (SW3), wenn der Betrag des ersten Gleichtaktspannungshubes größer ist als der erste Schwellwert (SW1).

Gemäß einer vierten Variante wird die Aufgabe erfindungsgemäß gelöst durch ein Verfahren, bei dem die Detektion eines zu großen Gleichtaktspannungshubes durch den Sender erfolgt, wobei der Empfänger einen Schmitt-Trigger zum Vergleich des Gleichtaktspannungshubes aufweist, nämlich durch ein Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) zur Erzeugung von Spannungsdifferenzen (über der Zeit) zwischen diesen,
c) Empfangen der Daten durch den Empfänger (E) mittels Erfassung der Spannungsdifferenzen zwischen dem dritten Anschluss (A3) und dem vierten Anschluss (A4) des Empfängers (E),
d) Vergleichen der zwischen dem dritten und dem vierten Anschluss (A3,A4) des Empfängers (E) gegebenen Spannungsdifferenzen mit einer unteren Empfangsschwelle (SW4), wobei bei Spannungsdifferenzen unterhalb dieser unteren Empfangsschwelle (SW4) ein Ausgang (O) einer den Vergleich ausführenden Teilvorrichtung (CMP3) einen ersten Pegel annimmt, dem ein erster logischer Wert zugeordnet ist, und mit einer oberen Empfangsschwelle (SW5), wobei bei Spannungsdifferenzen oberhalb dieser oberen Empfangsschwelle (SW5) ein bzw. der Ausgang (O) einer bzw. der den Vergleich ausführenden Teilvorrichtung (CMP3) einen zweiten Pegel annimmt, dem ein zweiter logischer Wert zugeordnet ist, der zum ersten logischen Wert komplementär ist,
e) Vergleichen des Betrags des erfassten zweiten Gleichtaktspannungshubes mit einem zweiten Schwellwert (SW2) und (insbesondere empfängerseitiges) Anheben der oberen Empfangsschwelle (SW5) sowie Absenken der unteren Empfangsschwelle (SW4), wenn der Betrag des zweiten Gleichtaktspannungshubes größer ist als der zweite Schwellwert (SW2.

Gemäß einer fünften Variante wird die Aufgabe erfindungsgemäß gelöst durch ein Verfahren, bei dem die Detektion eines zu großen Gleichtaktspannungshubes durch sowohl den Sender als auch den Empfänger erfolgt, wobei der Empfänger einen Schmitt-Trigger zum Vergleich des Gleichtaktspannungshubes aufweist, nämlich durch ein Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
c) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
   i) wobei der erste Treiber (D1) die erste Datenleitung (d1) mit einem ersten Offset (O1) und einem ersten Spannungspegel (P1) treibt,
   ii) wobei der zweite Treiber (D2) die zweite Datenleitung (d2) mit einem zweiten Offset (O2) und einem zweiten Spannungspegel (P2) treibt und
   iii) wobei der differentielle Sendepegel die Differenz aus dem ersten Spannungspegel (P1) und dem zweiten Spannungspegel (P2) ist,
d) Empfangen der Daten durch den Empfänger (E) mittels Erfassung der Spannungsdifferenzen (über der Zeit) zwischen dem dritten Anschluss (A3) und dem vierten Anschluss (A4) des Empfängers (E),
e) Vergleichen der zwischen dem dritten und dem vierten Anschluss (A3,A4) des Empfängers (E) gegebenen Spannungsdifferenzen mit einer unteren Empfangsschwelle (SW4), wobei bei Spannungsdifferenzen unterhalb dieser unteren Empfangsschwelle (SW4) ein Ausgang (O) einer den Vergleich ausführenden Teilvorrichtung (CMP3) einen ersten Pegel annimmt, dem ein erster logischer Wert zugeordnet ist, und mit einer oberen Empfangsschwelle (SW5), wobei bei Spannungsdifferenzen oberhalb dieser oberen Empfangsschwelle (SW5) ein bzw. der Ausgang (O) einer bzw. der den Vergleich ausführenden Teilvorrichtung (CMP3) einen zweiten Pegel annimmt, dem ein zweiter logischer Wert zugeordnet ist, der zum ersten logischen Wert komplementär ist,
f) Vergleichen des Betrags des erfassten ersten Gleichtaktspannungshubes mit einem ersten Schwellwert (SW1) und (insbesondere senderseitiges) Anheben des differentiellen Sendepegels, wenn der Betrag des ersten Gleichtaktspannungshubes größer ist als der erste Schwellwert (SW1),
g) Vergleichen des Betrags des erfassten zweiten Gleichtaktspannungshubes mit einem zweiten Schwellwert (SW2) und (insbesondere empfängerseitiges) Anheben der oberen Empfangsschwelle (SW5) sowie Absenken der unteren Empfangsschwelle (SW4), wenn der Betrag des zweiten Gleichtaktspannungshubes größer ist als der zweite Schwellwert (SW2), und
h) Übertragen eines Datums vom Sender (S) zum Empfänger (E), das von dem Ergebnis des Vergleichs des Betrags des erfassten ersten Gleichtaktspannungshubes mit dem ersten Schwellwert (SW1) abhängt, (d.h. das qualitativ repräsentiert, ob der Betrag des erfassten ersten Gleichtaktspannungshubes größer oder kleiner ist als der erste Schwellwert (oder gleich dem ersten Schwellwert) ist, oder dass zusätzlich noch quantitativ die Größe zwischen beiden repräsentiert) und (insbesondere empfängerseitiges) Anheben der oberen Empfangsschwelle (SW5) sowie Absenken der unteren Empfangsschwelle (SW4), wenn der Betrag des ersten Gleichtaktspannungshubes größer ist als der erste Schwellwert (SW1).

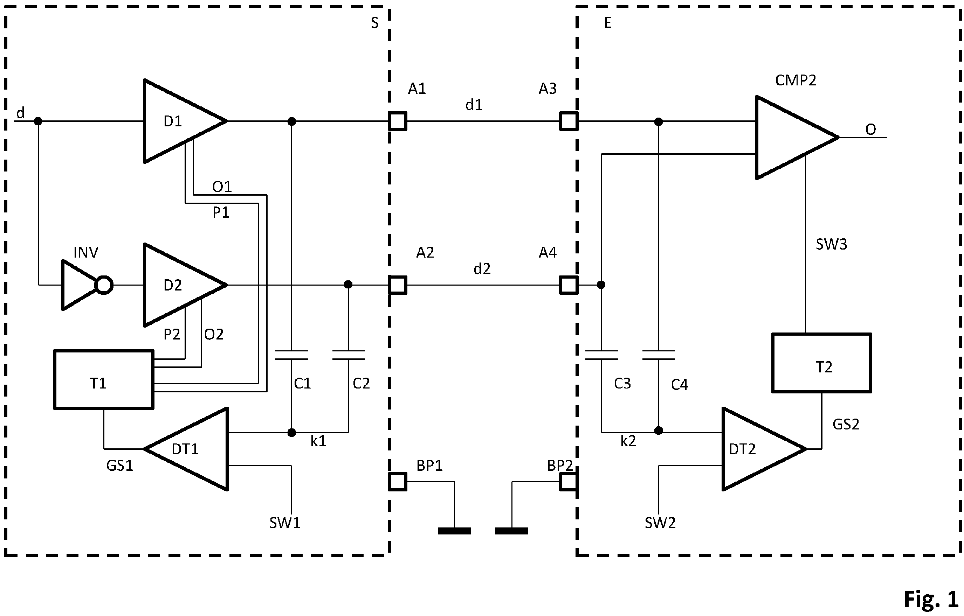

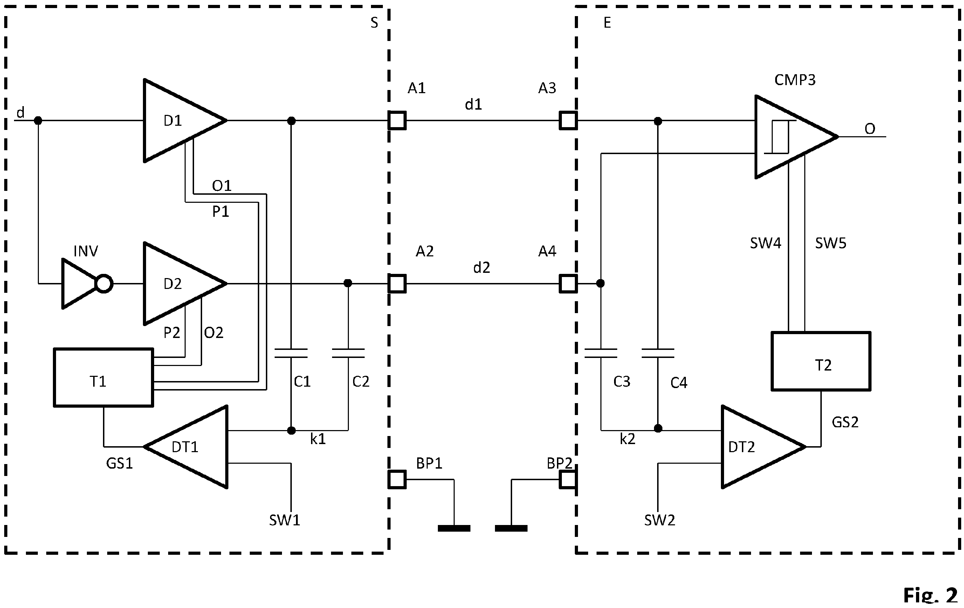

Ausführungsbeispiele der Erfindung sind in den Fign. 1 und 2 gezeigt.

Das erfindungsgemäße Datenbussystem soll zur Übertragung von Daten d mittels digitaler Spannungssignale auf einem Zweidrahtdatenbus Z in einem Automobil von einem Sender S zu einem Empfänger E dienen.

Die erfindungsgemäße Unterdrückung von Gleichtaktstörungen basiert auf der Idee, mittels eines zweiten Gleichtaktdetektors DT2 auf Seiten des Empfängers E oder mittels eines ersten Gleichtaktdetektors DT1 auf Seiten des Senders S oder mittels beider Gleichtaktdetektoren DT1,DT2 das Gleichtaktverhalten des Zweidrahtdatenbusses Z unmittelbar am Empfänger E durch sender- und/oder empfängerseitiges Vermessen der Gleichtaktwerte zu beobachten, das Vorliegen einer Gleichtaktstörung zu detektieren und Gegenmaßnahmen einzuleiten. Hier sei darauf hingewiesen, dass sich der Zweidrahtdatenbus Z bei einer derartig kritischen Gleichtaktstörung, die den ordnungsgemäßen Empfang der Daten auf dem Zweidrahtdatenbus Z behindert, bereits typischerweise nicht mehr in einem spezifikationskonformen Zustand befindet. Ziel der Maßnahmen ist also nicht, den spezifikationskonformen Zustand auf dem Zweidrahtdatenbus Z wieder herzustellen, sondern den ordnungsgemäßen Empfang der Daten und das Senden der Daten trotz Abweichung von der Spezifikation weiterhin zu ermöglichen, ohne die Empfangsqualität für andere Busteilnehmer zu vermindern. Die eingeleiteten Gegenmaßnahmen sind daher nicht für alle Zweidrahtdatenbusse als spezifikationskonform anzunehmen, sondern müssen von Fall zu Fall und von Bus-Spezifikation zu Bus-Spezifikation angepasst werden. Eine ausreichend starke Gleichtaktstörung bringt den Zweidrahtdatenbus Z in einen nicht spezifikationskonformen Zustand. Oberste Priorität hat in jedem Fall die Wiederherstellung eines korrekten Datenempfangs unter diesen von außen eingeprägten, nicht die Wiederherstellung der spezifikationskonformen Betriebsbedingungen.

Beide Gleichtaktdetektoren DT1,DT2 werden vorzugsweise an ein Bezugspotenzial BP1,BP2 fest angebunden und beobachten das Gleichtaktsignal auf der Datenbusleitung d1,d2 vorzugsweise durch kapazitive Kopplung.

Der Sender S weist einen ersten Anschluss A1 zum Anschluss an einer ersten Datenbusleitung d1 des Zweidrahtdatenbusses Z und einen zweiten Anschluss A2 zum Anschluss an einer zweiten Datenbusleitung d2 des Zweidrahtdatenbusses Z sowie einen ersten Bezugspotenzialanschluss BP1 auf.

Der Empfänger E weist einen dritten Anschluss A3 zum Anschluss an der ersten Datenbusleitung d1 des Zweidrahtdatenbusses Z und einen vierten Anschluss A4 zum Anschluss an der zweiten Datenbusleitung d2 des Zweidrahtdatenbusses Z sowie einen zweiten Bezugspotenzialanschluss BP2 auf.

Des Weiteren weist der Sender S eine Teilvorrichtung C1,C2 auf, die den ersten Gleichtaktspannungshub an dem ersten Anschluss A1 und an dem zweiten Anschluss A2 gegenüber dem ersten Bezugspotenzialanschluss BP1 erfasst und ein erstes Gleichtaktsignal k1 erzeugt.

Der Empfänger E weist weiter eine Teilvorrichtung C3,C4 auf, die den zweiten Gleichtaktspannungshub an dem dritten Anschluss A3 und an dem vierten Anschluss A4 gegenüber dem zweiten Bezugspotenzialanschluss BP2 erfasst und ein zweites Gleichtaktsignal k2 erzeugt.

Der Sender S weist einen ersten Treiber D1 auf, der zum Senden von Daten d mittels eines digitalen differentiellen Spannungssignals über den Zweidrahtdatenbus Z an den ersten Anschluss A1 und damit an die erste Datenleitung d1 des Zweidrahtdatenbusses Z angeschlossen ist. Der erste Treiber D1 steuert die erste Datenleitung d1 des Zweidrahtdatenbusses Z mit einem Signal mit einem ersten Spannungspegel P1 und mit einem ersten Offset O1 an. Dabei entspricht der erste Spannungspegel P1 der Signalamplitude und der erste Offset O1 einer ersten Versatzspannung, um den das Signal auf der ersten Datenleitung d1 des Zweidrahtdatenbusses Z dann gegen das Bezugspotenzial additiv abgesenkt oder angehoben ist.

Darüber hinaus besitzt der Sender S einen zweiten Treiber D2, der zum Senden von Daten d mittels eines digitalen differentiellen Spannungssignals über den Zweidrahtdatenbus Z an den zweiten Anschluss A2 und damit an die zweite Datenleitung d2 des Zweidrahtdatenbusses Z angeschlossen ist. Der zweite Treiber D2 steuert die zweite Datenleitung d2 des Zweidrahtdatenbusses Z mit einem Signal mit einem zweiten Spannungspegel P2 und mit einem zweiten Offset O2 an. Dabei entspricht der zweite Spannungspegel P2 der Signalamplitude und der zweite Offset O12 einer zweiten Versatzspannung, um den das Signal auf der zweiten Datenleitung d2 des Zweidrahtdatenbusses Z dann gegen das Bezugspotenzial additiv abgesenkt oder angehoben ist.

Im Empfänger E befindet sich eine Empfangsvorrichtung, insbesondere ein Schmitt-Trigger CMP2, die bzw. der die von dem Sender auf den Zweidrahtdatenbus Z gesendeten Daten d empfängt, und zwar mittels Erfassung der Spannungsdifferenz zwischen einem dritten Anschluss A3, an den die erste Datenbusleitung d1 angeschlossen ist, und einem vierten Anschluss A4, an den die zweite Datenbusleitung d2 angeschlossen ist.

Erfindungsgemäß überwachen somit sowohl der Empfänger E als auch der Sender S den Zweidrahtdatenbus Z auf Gleichtaktstörungen. Wird durch den ersten Gleichtaktdetektor DT1 des Senders S eine Gleichtaktstörung auf dem Zweidrahtdatenbus Z detektiert, so erhöht der Sender S seinen Sende-Pegel. Wird durch den zweiten Gleichtaktdetektor DT2 auf der Seite des Empfängers E eine Gleichtaktstörung detektiert, so erhöht der Empfänger E seine obere Empfangsschwelle SW5 und verringert seine untere Empfangsschwelle SW4 für die Unterscheidung zwischen den zwei logischen Pegeln, so dass der Störabstand erhöht wird. Die untere Empfangsschwelle SW4 und die obere Empfangsschwelle SW5 stellen dabei beispielsweise die Empfangsschwellen einer Schmitt-Trigger-Schaltung CMP3 dar, die den differentiellen Spannungspegel auf dem Zweidrahtdatenbus Z auswertet. Selbstverständlich kann hier bei der Verwendung eines einfachen Komparators CMP2 auch nur mit einem einzigen Schwellwert SW3 gearbeitet werden.

Dabei ist eine synchrone Erhöhung des Abstands der oberen und unteren Empfangsschwelle SW5,SW4 auf Seiten des Empfängers E mit einer Erhöhung des ersten Spannungspegels P1 und des zweiten Spannungspegels P2 auf der Seite des Senders S nicht unbedingt erforderlich.

Wichtig ist, dass der Empfänger E den Abstand zwischen der oberen und der unteren Empfangsschwellen SW5,SW4 für den Empfang bei einem durch eine Gleichtaktstörung gestörten Empfang nicht so weit anhebt, dass die obere und untere Empfangsschwelle SW5,SW4 oberhalb eines (noch) spezifikationskonformen Werts liegen würden.

Eine Vorrichtung führt also ein erfindungsgemäßes Verfahren zur Übertragung von Daten mittels digitaler Spannungssignale auf einem Zweidrahtdatenbus Z in einem Automobil aus. Die digitalen Spannungssignale können dabei zwischen zwei Grenzwerten lediglich endlich viele Werte annehmen. Ein binäres Signal ist insoweit als Spezialfall eines Digitalsignals anzusehen, als es sich um ein zweistufiges Digitalsignal handelt, das lediglich zwei Werte annehmen kann. Nach der Erfindung werden Daten von einem Sender S zu einem Empfänger E vorzugsweise als differentielles Spannungssignal übertragen. Der Sender S verfügt dabei über den ersten Anschluss A1, der mit der ersten Datenbusleitung d1 des Zweidrahtdatenbusses Z verbunden ist, und über den zweiten Anschluss A2, der mit der zweiten Datenbusleitung d2 des Zweidrahtdatenbusses Z verbunden ist, und über einen senderseitigen ersten Bezugspotenzialanschluss BP1, der durch ein vorzugsweises festes Spannungsverhältnis mit dem zweiten Bezugspotenzialanschluss BP2 des Empfängers E verbunden ist. Vorzugsweise handelt es sich um eine gemeinsame Bezugsmasse, die spannungsmäßig möglichst wenig abweichen sollte. Der Empfänger E auf der anderen Seite der Datenbusleitung d1,d2 verfügt über den dritten Anschluss A3, der mit der ersten Datenbusleitung d1 des Zweidrahtdatenbusses Z verbunden ist, und über den vierten Anschluss A4, der mit der zweiten Datenbusleitung d2 des Zweidrahtdatenbusses Z verbunden ist, sowie den besagten zweiten Bezugspotenzialanschluss BP2. Das Zweidrahtdatenbussystem führt nun folgendes erfindungsgemäßes Verfahren zur Erhöhung des Störabstandes der Datenübertragung durch:
Ein sich möglicherweise gegenüber dem ersten Bezugspotenzialanschluss BP1 einstellender erster Gleichtaktspannungshub an dem ersten und dem zweiten Anschluss A1,A2 des Senders S wird durch einen ersten Gleichtaktdetektor DT1, der vorzugsweise Teil des Senders S ist, erfasst. Hierbei handelt es sich vorzugsweise um den Mittelwert der Spannung an dem ersten Anschluss A1 und dem zweiten Anschluss A2. In dem Beispiel der Fig. 1 wird dieser Mittelwert durch einen vorzugsweise kapazitiven Spannungsteiler, bestehend aus dem ersten Kondensator C1 und dem zweiten Kondensator C2 oder einem andersartigen Spannungsteiler, aus dem Potenzial der ersten Datenbusleitung d1 und dem Potenzial der zweiten Datenbusleitung d2 als erstes Gleichtaktsignal k1 gebildet.

Ein sich möglicherweise gegenüber dem zweiten Bezugspotenzialanschluss BP2 einstellender zweiter Gleichtaktspannungshub an dem dritten und dem vierten Anschluss A3,A4 des Empfängers E wird durch einen zweiten Gleichtaktdetektor DT2 erfasst. Hierbei handelt es sich vorzugsweise um den Mittelwert der Spannung an dem dritten Anschluss A3 und dem vierten Anschluss A4. In dem Beispiel der Fig. 1 wird dieser Mittelwert durch einen vorzugsweise kapazitiven oder anderen Spannungsteiler, bestehend aus dem dritten Kondensator C3 und dem vierten Kondensator C4, zwischen dem Potenzial der ersten Datenbusleitung d1 und dem Potenzial der zweiten Datenbusleitung d2 als zweites Gleichtaktsignal k2 gebildet.

Der Sender S sendet Daten mittels eines digitalen Spannungssignals zwischen dem ersten Anschluss A1 und dem zweiten Anschluss A2 des Senders S über den Zweidrahtdatenbus mit einem differentiellen Sende-Pegel. Der differentielle Sendepegel ist dabei die Spannungsdifferenz zwischen einem ersten Spannungspegel P1, mit dem der erste Treiber D1 des Senders S die erste Datenbusleitung d1 treibt, und einem zweiten Spannungspegel P2, mit dem der zweite Treiber D2 des Senders S die zweite Datenbusleitung d2 treibt.

Der Empfänger E empfängt die Daten mittels Messung der Spannungsdifferenz zwischen seinem dritten und seinem vierten Anschluss A3,A4 und mittels anschließendem Vergleich dieser gemessenen Spannungsdifferenz mit einem dritten Schwellwert. In dem Beispiel der Fig. 1 wird der Vergleich mit dem dritten Schwellwert SW3 mittels eines empfängerseitigen Komparators CMP2 realisiert, während bei dem Ausführungsbeispiel nach Fig. 2 statt eines empfängerseitigen Komparators ein Schmitt-Trigger CMP3 verwendet wird. Dementsprechend wird die Spannungsdifferenz zwischen dem dritten und dem vierten Anschluss A3,A4 mit einer unteren Empfangsschwelle SW4 des Schmitt-Triggers CMP3 des Empfängers E und mit einer oberen Empfangsschwelle SW5 des Schmitt-Triggers CMP3 des Empfängers E vergleichen. Dem dritten Schwellwert SW3 des Ausführungsbeispiels nach Fig. 1 entsprechen also im Ausführungsbeispiel gemäß Fig. 2 die unteren und oberen Empfangsschwellen SW4 und SW5. Allgemein ausgedrückt wird also die Spannungsdifferenz zwischen dem dritten und dem vierten Anschluss A3,A4 des Empfängers E auf Unterschreitung einer unteren Empfangsschwelle SW4 bzw. auf Überschreitung einer oberen Empfangsschwelle SW5 untersucht (siehe Fig. 2), wobei diese beiden Empfangsschwelle SW4,SW5 zusammenfallen können und somit den dritten Schwellwert SW3 des Ausführungsbeispiels gemäß Fig. 1 bilden.

Gemäß Fig. 2 werden durch den Empfänger Spannungsdifferenzen oberhalb einer oberen Empfangsschwelle SW5 des empfängerseitigen Schmitt-Triggers CMP3 ein erster logischer Wert zugeordnet. Demgegenüber werden Spannungsdifferenzen unterhalb einer unteren Empfangsschwelle SW4 des empfängerseitigen Schmitt-Triggers CMP3 ein zum ersten logischen Wert invertierter zweiter logischer Wert zugeordnet.

Der erste Gleichtaktdetektor DT1 vergleicht den erfassten Betrag des ersten Gleichtaktsignals k1 mit einem ersten Schwellwert SW1 und erzeugt ein erstes Signal für den Gleichtaktspannungshub GS1. Statt des Vergleichs mit einem ersten Schwellwert SW1 kann der Gleichtaktspannungshub mit einem ersten Schwellwertbereich verglichen werden, d.h. es kann untersucht werden, ob der Gleichtaktspannungshub größer als ein oberer Grenzwert oder kleiner als ein unterer Grenzwert des ersten Schwellwertbereichs ist.

Eine erste Teilvorrichtung T1 wertet das Signal für den ersten Gleichtaktspannungshub GS1 aus und hebt den ersten Spannungspegel P1, mit dem der erste Treiber D1 des Senders S die erste Datenbusleitung d1 treibt, an, wenn der Betrag des ersten Gleichtaktspannungshubes auf dem ersten Gleichtaktsignal k1 größer als dieser erste Schwellwert SW1 ist. Die erste Teilvorrichtung T1 werten das Signal für den ersten Gleichtaktspannungshub GS1 aus und hebt den zweiten Spannungspegel P2, mit dem der zweite Treiber D2 des Senders S die zweite Datenbusleitung d2 treibt, an, wenn dieser Betrag des Gleichtaktspannungshubes auf dem ersten Gleichtaktsignal k1 größer als der erste Schwellwert SW1 ist.

Der zweite Gleichtaktdetektor DT2 vergleicht den erfassten Betrag des zweiten Gleichtaktsignals k2 mit einem zweiten Schwellwert SW2 und erzeugt ein zweites Signal für den Gleichtaktspannungshub GS2. Statt des Vergleichs mit einem zweiten Schwellwert SW2 kann der Gleichtaktspannungshub mit einem zweiten Schwellwertbereich verglichen werden, d.h. es kann untersucht werden, ob der Gleichtaktspannungshub größer als ein oberer Grenzwert oder kleiner als ein unterer Grenzwert des zweiten Schwellwertbereichs ist.

Eine zweite Teilvorrichtung T2 wertet das Signal für den zweiten Gleichtaktspannungshub GS2 aus und hebt die obere Empfangsschwelle SW5 des empfängerseitigen Schmitt-Triggers CMP2 an, wenn der Betrag des zweiten Gleichtaktspannungshubes auf dem zweiten Gleichtaktsignal k2 größer als dieser zweite Schwellwert SW2 ist. Die zweite Teilvorrichtung T2 wertet das Signal für den zweiten Gleichtaktspannungshub GS2 aus und senkt die untere Empfangsschwelle SW4 des empfängerseitigen Schmitt-Triggers CMP2 ab, wenn dieser Betrag des Gleichtaktspannungshubes auf dem zweiten Gleichtaktsignal k2 größer als der zweite Schwellwert SW2 ist.

In einer besonderen Ausprägung der Erfindung wird der Vergleich des Betrags des erfassten ersten Gleichtaktspannungshubes auf dem ersten Gleichtaktsignal k1 mit einem ersten Schwellwert SW1 ebenfalls durchgeführt. Wenn der Betrag des ersten Gleichtaktspannungshubes auf dem ersten Gleichtaktsignal k1 größer ist als der erste Schwellwert SW1, so erfolgt dann in dieser speziellen Variante eine Anhebung eines ersten Offsets O1, mit dem der erste Treiber D1 des Senders S die erste Datenbusleitung d1 des Zweidrahtdatenbusses Z treibt, und/oder eine Anhebung eines zweiten Offsets O2, mit dem der zweite Treiber D2 des Senders S die zweite Datenbusleitung d2 des Zweidrahtdatenbusses Z treibt.

In einer weiteren Variante des Verfahrens zur Übertragung von Daten d erfolgt eine Übertragung eines Datums vom Sender S zum Empfänger E, das von dem Ergebnis des Vergleichs des Betrags des erfassten ersten Gleichtaktspannungshubes auf dem ersten Gleichtaktsignal k1 mit einem ersten Schwellwert SW1 abhängt. Hierzu kann beispielsweise ein Mikrokontroller dieses Ergebnis über ein Register auslesen und mittels des Zweidrahtdatenbusses Z ein Register im Empfänger beschreiben. Im Empfänger E erfolgt daraufhin eine Anhebung des dritten Schwellwertes SW3, wenn dieser Betrag des ersten Gleichtaktspannungshubes auf dem ersten Gleichtaktsignal k1 größer ist als der erste Schwellwert SW1. Sofern kein einzelner Schwellwert verwendet wird sondern ein Schmitt-Trigger mit zwei Schwellwerten, erfolgt beispielsweise eine Anhebung der oberen Empfangsschwelle SW4 und/oder gegebenenfalls eine Absenkung der unteren Empfangsschwelle SW3, wenn dieser Betrag des ersten Gleichtaktspannungshubes auf dem ersten Gleichtaktsignal k1 größer ist als der erste Schwellwert SW1.

Der sich aus der Erfindung ergebende Vorteil stellt sich nun so dar, dass bei einer zu großen Gleichtaktwechselspannung auf dem Bus gegen Masse der negative Effekt der Amplitude der Gleichtaktwechselspannung im System selbst verringert wird, da die Amplitude der Gleichtaktwechselspannung gegenüber dem Nutzsignal relativ verkleinert wird.

### BEZUGSZEICHENLISTE

- A1: erster Anschluss des Senders S für die erste Datenbusleitung d1
- A2: zweiter Anschluss des Senders S für die erste Datenbusleitung d1
- A3: dritter Anschluss des Empfängers E für die erste Datenbusleitung d1
- A4: vierter Anschluss des Empfängers E für die zweite Datenbusleitung d2
- BP1: erster Bezugspotenzialanschluss des Senders S. Die Verteilung des Bezugspotenzials innerhalb des Senders S ist dem Fachmann geläufig und ist in Fig. 1 daher nicht extra dargestellt.
- BP2: zweiter Bezugspotenzialanschluss des Empfängers E. Die Verteilung des Bezugspotenzials innerhalb des Empfängers E ist dem Fachmann geläufig und ist in Fig. 1 daher nicht extra dargestellt.
- C1: erster Kondensator
- C2: zweiter Kondensator
- C3: dritter Kondensator
- C4: vierter Kondensator
- CMP1: senderseitiger Komparator
- CMP2: empfängerseitiger Komparator
- CMP3: Schmitt-Trigger des Empfängers E
- d: Sendedaten (Eingang)
- d1: erste Datenbusleitung
- d2: zweite Datenbusleitung
- D1: erster Treiber des Senders S, der die erste Datenbusleitung d1 des Zweidrahtdatenbusses Z treibt
- D2: zweiter Treiber des Senders S, der die zweite Datenbusleitung d2 des Zweidrahtdatenbusses Z treibt
- DT1: erster Gleichtaktdetektor
- DT2: zweiter Gleichtaktdetektor
- E: Empfänger
- INV: Inverter
- GS1: erstes Signal für den ersten Gleichtaktspannungshub auf dem ersten Gleichtaktsignal k1 auf Seite des Senders S
- GS2: zweites Signal für den zweiten Gleichtaktspannungshub auf dem zweiten Gleichtaktsignal k2 auf Seite des Empfängers E
- k1: erstes Gleichtaktsignal auf Seite des Senders S
- k2: zweites Gleichtaktsignal auf Seite des Empfängers E
- O: Ausgang des Schmitt-Triggers mit Nutzdaten
- O1: erster Offset
- O2: zweiter Offset
- P1: erster Spannungspegel mit dem der erste Treiber D1 des Senders S die erste Datenbusleitung d1 des Zweidrahtdatenbusses Z treibt.
- P2: zweiter Spannungspegel mit dem der zweite Treiber D2 des Senders S die zweite Datenbusleitung d2 des Zweidrahtdatenbusses Z treibt.
- S: Sender
- SW1: erster Schwellwert
- SW2: zweiter Schwellwert
- SW3: dritter Schwellwert
- SW4: untere Empfangsschwelle des Schmitt-Triggers CMP3 des Empfängers E
- SW5: obere Empfangsschwelle des Schmitt-Triggers CMP3 des Empfängers E
- T1: erste Teilvorrichtung
- T2: zweite Teilvorrichtung
- Z: Zweidrahtdatenbus

## Patentansprüche

1. Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
i) wobei der erste Treiber (D1) die erste Datenleitung (d1) mit einem ersten Offset (O1) und einem ersten Spannungspegel (P1) treibt,
ii) wobei der zweite Treiber (D2) die zweite Datenleitung (d2) mit einem zweiten Offset (O2) und einem zweiten Spannungspegel (P2) treibt und
iii) wobei der differentielle Sendepegel die Differenz aus dem ersten Spannungspegel (P1) und dem zweiten Spannungspegel (P2) ist,
c) Empfangen der Daten durch den Empfänger (E) mittels Erfassung der Spannungsdifferenzen zwischen dem dritten Anschluss (A3) und dem vierten Anschluss (A4) des Empfängers (E) und
d) Vergleichen des Betrags des erfassten ersten Gleichtaktspannungshubes mit einem ersten Schwellwert (SW1),
**gekennzeichnet durch**
e) Anheben des differentiellen Sendepegels, wenn der Betrag des ersten Gleichtaktspannungshubes größer ist als der erste Schwellwert (SW1).

2. Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) zur Erzeugung von Spannungsdifferenzen zwischen diesen,
c) Empfangen der Daten durch den Empfänger (E) mittels Erfassung der Spannungsdifferenzen zwischen dem dritten Anschluss (A3) und dem vierten Anschluss (A4) des Empfängers (E) und
d) Vergleichen der zwischen dem dritten und dem vierten Anschluss (A3,A4) des Empfängers (E) gegebenen Spannungsdifferenzen mit einem dritten Schwellwert (SW3), wobei Spannungsdifferenzen oberhalb dieses dritten Schwellwerts (SW3) ein erster logischer Wert zugeordnet wird und Spannungsdifferenzen unterhalb dieses dritten Schwellwerts (SW3) ein zum ersten logischen Wert invertierter zweiter logischer Wert zugeordnet wird,
**gekennzeichnet durch**
e) Vergleichen des Betrags des erfassten zweiten Gleichtaktspannungshubes mit einem zweiten Schwellwert (SW2) und
f) Anheben des dritten Schwellwerts (SW3), wenn der Betrag des zweiten Gleichtaktspannungshubes größer ist als der zweite Schwellwert (SW2).

3. Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
c) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
i) wobei der erste Treiber (D1) die erste Datenleitung (d1) mit einem ersten Offset (O1) und einem ersten Spannungspegel (P1) treibt,
ii) wobei der zweite Treiber (D2) die zweite Datenleitung (d2) mit einem zweiten Offset (O2) und einem zweiten Spannungspegel (P2) treibt und
iii) wobei der differentielle Sendepegel die Differenz aus dem ersten Spannungspegel (P1) und dem zweiten Spannungspegel (P2) ist,
d) Empfangen der Daten durch den Empfänger (E) mittels Erfassung der Spannungsdifferenzen zwischen dem dritten Anschluss (A3) und dem vierten Anschluss (A4) des Empfängers (E),
e) Vergleichen der zwischen dem dritten und dem vierten Anschluss (A3,A4) des Empfängers (E) gegebenen Spannungsdifferenzen mit einem dritten Schwellwert (SW3), wobei Spannungsdifferenzen oberhalb dieses dritten Schwellwerts (SW3) ein erster logischer Wert zugeordnet wird und Spannungsdifferenzen unterhalb dieses dritten Schwellwerts (SW3) ein zum ersten logischen Wert invertierter zweiter logischer Wert zugeordnet wird,
f) Vergleichen des Betrags des erfassten ersten Gleichtaktspannungshubes mit einem ersten Schwellwert (SW1) und Anheben des differentiellen Sendepegels, wenn der Betrag des ersten Gleichtaktspannungshubes größer ist als der erste Schwellwert (SW1),
g) Vergleichen des Betrags des erfassten zweiten Gleichtaktspannungshubes mit einem zweiten Schwellwert (SW2) und Anheben des dritten Schwellwerts (SW3), wenn der Betrag des zweiten Gleichtaktspannungshubes größer ist als der zweite Schwellwert (SW2), und
h) Übertragen eines Datums vom Sender (S) zum Empfänger (E), das von dem Ergebnis des Vergleichs des Betrags des erfassten ersten Gleichtaktspannungshubes mit dem ersten Schwellwert (SW1) abhängt Anheben des dritten Schwellwerts (SW3), wenn der Betrag des ersten Gleichtaktspannungshubes größer ist als der erste Schwellwert (SW1).

4. Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
b) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) zur Erzeugung von Spannungsdifferenzen zwischen diesen,
c) Empfangen der Daten durch den Empfänger (E) mittels Erfassung der Spannungsdifferenzen zwischen dem dritten Anschluss (A3) und dem vierten Anschluss (A4) des Empfängers (E),
d) Vergleichen der zwischen dem dritten und dem vierten Anschluss (A3,A4) des Empfängers (E) gegebenen Spannungsdifferenzen mit einer unteren Empfangsschwelle (SW4), wobei bei Spannungsdifferenzen unterhalb dieser unteren Empfangsschwelle (SW4) ein Ausgang (O) einer den Vergleich ausführenden Teilvorrichtung (CMP3) einen ersten Pegel annimmt, dem ein erster logischer Wert zugeordnet ist, und mit einer oberen Empfangsschwelle (SW5), wobei bei Spannungsdifferenzen oberhalb dieser oberen Empfangsschwelle (SW5) ein bzw. der Ausgang (O) einer bzw. der den Vergleich ausführenden Teilvorrichtung (CMP3) einen zweiten Pegel annimmt, dem ein zweiter logischer Wert zugeordnet ist, der zum ersten logischen Wert komplementär ist,
e) Vergleichen des Betrags des erfassten zweiten Gleichtaktspannungshubes mit einem zweiten Schwellwert (SW2) und Anheben der oberen Empfangsschwelle (SW5) sowie Absenken der unteren Empfangsschwelle (SW4), wenn der Betrag des zweiten Gleichtaktspannungshubes größer ist als der zweite Schwellwert (SW2.

5. Verfahren zur Übertragung von Daten (d) mittels digitaler Spannungssignale über einen Zweidrahtdatenbus (Z) eines Fahrzeugs von einem Sender (S) zu einem Empfänger (E) unter dem Einfluss von auf den Zweidrahtdatenbus (Z) einwirkenden Gleichtaktstörungen,
- wobei der Zweidrahtdatenbus (Z) eine erste Datenbusleitung (d1) und eine zweite Datenbusleitung (d2) aufweist,
- wobei der Sender (S) einen an die erste Datenbusleitung (d1) angeschlossenen ersten Anschluss (A1) sowie einen an die zweite Datenbusleitung (d2) angeschlossenen zweiten Anschluss (A2) sowie einen ersten Bezugspotenzialanschluss (BP1) aufweist,
- wobei der Sender (S) einen ersten Treiber (D1) für den ersten Anschluss (A1) und einen zweiten Treiber (D2) für den zweiten Anschluss (A1) aufweist und
- wobei der Empfänger (E) einen an die erste Datenbusleitung (d1) angeschlossenen dritten Anschluss (A3) sowie einen an die zweite Datenbusleitung (d2) angeschlossenen vierten Anschluss (A4) und einen zweiten Bezugspotenzialanschluss (BP2) aufweist,
mit den folgenden Schritten:
a) Erfassen eines ersten Gleichtaktspannungshubes an dem ersten und dem zweiten Anschluss (A1,A2) des Senders (S) gegenüber dem ersten Bezugspotenzialanschluss (BP1) und Bilden eines ersten Gleichtaktsignals (k1),
b) Erfassen eines zweiten Gleichtaktspannungshubes an dem dritten und dem vierten Anschluss (A3,A4) des Empfängers (E) gegenüber dem zweiten Bezugspotenzialanschluss (BP2) und Bilden eines zweiten Gleichtaktsignals (k2),
c) Senden von Daten (d) durch den Sender (S) über den Zweidrahtdatenbus (Z) an den Empfänger (E) durch Anlegen eines digitalen Spannungssignals zwischen dem ersten und dem zweiten Anschluss (A1,A2) des Senders (S) mit einem differentiellen Sendepegel,
i) wobei der erste Treiber (D1) die erste Datenleitung (d1) mit einem ersten Offset (O1) und einem ersten Spannungspegel (P1) treibt,
ii) wobei der zweite Treiber (D2) die zweite Datenleitung (d2) mit einem zweiten Offset (O2) und einem zweiten Spannungspegel (P2) treibt und
iii) wobei der differentielle Sendepegel die Differenz aus dem ersten Spannungspegel (P1) und dem zweiten Spannungspegel (P2) ist,
d) Empfangen der Daten durch den Empfänger (E) mittels Erfassung der Spannungsdifferenzen zwischen dem dritten Anschluss (A3) und dem vierten Anschluss (A4) des Empfängers (E),
e) Vergleichen der zwischen dem dritten und dem vierten Anschluss (A3,A4) des Empfängers (E) gegebenen Spannungsdifferenzen mit einer unteren Empfangsschwelle (SW4), wobei bei Spannungsdifferenzen unterhalb dieser unteren Empfangsschwelle (SW4) ein Ausgang (O) einer den Vergleich ausführenden Teilvorrichtung (CMP3) einen ersten Pegel annimmt, dem ein erster logischer Wert zugeordnet ist, und mit einer oberen Empfangsschwelle (SW5), wobei bei Spannungsdifferenzen oberhalb dieser oberen Empfangsschwelle (SW5) ein bzw. der Ausgang (O) einer bzw. der den Vergleich ausführenden Teilvorrichtung (CMP3) einen zweiten Pegel annimmt, dem ein zweiter logischer Wert zugeordnet ist, der zum ersten logischen Wert komplementär ist,
f) Vergleichen des Betrags des erfassten ersten Gleichtaktspannungshubes mit einem ersten Schwellwert (SW1) und Anheben des differentiellen Sendepegels, wenn der Betrag des ersten Gleichtaktspannungshubes größer ist als der erste Schwellwert (SW1),
g) Vergleichen des Betrags des erfassten zweiten Gleichtaktspannungshubes mit einem zweiten Schwellwert (SW2) und Anheben der oberen Empfangsschwelle (SW5) sowie Absenken der unteren Empfangsschwelle (SW4), wenn der Betrag des zweiten Gleichtaktspannungshubes größer ist als der zweite Schwellwert (SW2), und
h) Übertragen eines Datums vom Sender (S) zum Empfänger (E), das von dem Ergebnis des Vergleichs des Betrags des erfassten ersten Gleichtaktspannungshubes mit dem ersten Schwellwert (SW1) abhängt, und Anheben der oberen Empfangsschwelle (SW5) sowie Absenken der unteren Empfangsschwelle (SW4), wenn der Betrag des ersten Gleichtaktspannungshubes größer ist als der erste Schwellwert (SW1).

## Claims

1. Method for transmitting data (d) from a transmitter (S) to a receiver (E) via a two-wire data bus (Z) of a vehicle, using digital voltage signals, under the influence of common-mode interferences acting on the two-wire data bus (Z),
- wherein the two-wire data bus (Z) comprises a first data bus line (d1) and a second data bus line (d2),
- wherein the transmitter (S) comprises a first port (A1) connected to the first data bus line (d1) and a second port (A2) connected to the second data bus line (A2), as well as a reference potential port (BP1),
- wherein the transmitter (S) comprises a first driver (D1) for the first port (A1) and a second driver (D2) for the second port (A1), and
- wherein the receiver (E) comprises a third port (A3) connected to the first data bus line (d1) and a fourth port (A4) connected to the second data bus line (d2), as well as a second reference potential port (BP2),
the method comprising the following steps:
a) sensing a first common-mode voltage swing at the first and second ports (A1, A2) of the transmitter (S) with respect to the first reference potential port (BP1) and forming a first common-mode signal (k1),
b) transmitting data (d) by the transmitter (S) to the receiver (E) via the two-wire data bus (Z) by applying a digital voltage signal between the first and second ports (A1, A2) of the transmitter (S) with a differential transmission level,
i) wherein the first driver (D1) drives the first data line (d1) with a first (O1) and a first voltage level (P1),
ii) wherein the second driver (D2) drives the second data line (d2) with a second offset (O2) and a second voltage level (P2), and
iii) wherein the differential transmission level is the difference from the first voltage level (P1) and the second voltage level (P2),
c) receiving the data by the receiver (E) by means of sensing the voltage differences between the third port (A3) and the fourth port (A4) of the receiver (E), and
d) comparing the amount of the sensed first common-mode voltage swing to a first threshold value (SW1),
**characterized by**
e) increasing the differential transmission level if the amount of the first common-mode voltage swing is greater than the first threshold value (SW1).

2. Method for transmitting data (d) from a transmitter (S) to a receiver (E) via a two-wire data bus (Z) of a vehicle, using digital voltage signals, under the influence of common-mode interferences acting on the two-wire data bus (Z),
- wherein the two-wire data bus (Z) comprises a first data bus line (d1) and a second data bus line (d2),
- wherein the transmitter (S) comprises a first port (A1) connected to the first data bus line (d1) and a second port (A2) connected to the second data bus line (A2), as well as a reference potential port (BP1),
- wherein the receiver (E) comprises a third port (A3) connected to the first data bus line (d1) and a fourth port (A4) connected to the second data bus line (d2), as well as a second reference potential port (BP2),
the method comprising the following steps:
a) sensing a second common-mode voltage swing at the third and fourth ports (A3, A4) of the receiver (E) with respect to the second reference potential port (BP2) and forming a second common-mode signal (k2),
b) transmitting data (d) by the transmitter (S) to the receiver (E) via the two-wire data bus (Z) by applying a digital voltage signal between the first and second ports (A1, A2) of the transmitter (S) for generating voltage differences between the same,
c) receiving the data by the receiver (E) by means of sensing the voltage differences between the third port (A3) and the fourth port (A4) of the receiver (E), and
d) comparing the voltage differences existing between the third and fourth ports (A3, A4) of the receiver (E) to a third threshold value (SW3), wherein a first logical value is allocated to voltage differences above this third threshold value (SW3) and a second logical value is allocated to voltage differences below this third threshold value (SW3), which second logical value is inverted with respect to the first logical value,
**characterized by**
e) comparing the amount of the sensed second common-mode voltage swing to a second threshold value (SW2), and
f) increasing the third threshold value (SW3) if the amount of the second common-mode voltage swing is greater than the second threshold value (SW2).

3. Method for transmitting data (d) from a transmitter (S) to a receiver (E) via a two-wire data bus (Z) of a vehicle, using digital voltage signals, under the influence of common-mode interferences acting on the two-wire data bus (Z),
- wherein the two-wire data bus (Z) comprises a first data bus line (d1) and a second data bus line (d2),
- wherein the transmitter (S) comprises a first port (A1) connected to the first data bus line (d1) and a second port (A2) connected to the second data bus line (A2), as well as a reference potential port (BP1),
- wherein the transmitter (S) comprises a first driver (D1) for the first port (A1) and a second driver (D2) for the second port (A1), and
- wherein the receiver (E) comprises a third port (A3) connected to the first data bus line (d1) and a fourth port (A4) connected to the second data bus line (d2), as well as a second reference potential port (BP2),
the method comprising the following steps:
a) sensing a first common-mode voltage swing at the first and second ports (A1, A2) of the transmitter (S) with respect to the first reference potential port (BP1) and forming a first common-mode signal (k1),
b) sensing a second common-mode voltage swing at the third and fourth ports (A3, A4) of the receiver (E) with respect to the second reference potential port (BP2) and forming a second common-mode signal (k2),
c) transmitting data (d) by the transmitter (S) to the receiver (E) via the two-wire data bus (Z) by applying a digital voltage signal between the first and second ports (A1, A2) of the transmitter (S) with a differential transmission level,
i) wherein the first driver (D1) drives the first data line (d1) with a first (O1) and a first voltage level (P1),
ii) wherein the second driver (D2) drives the second data line (d2) with a second offset (O2) and a second voltage level (P2), and
iii) wherein the differential transmission level is the difference from the first voltage level (P1) and the second voltage level (P2),
d) receiving the data by the receiver (E) by means of sensing the voltage differences between the third port (A3) and the fourth port (A4) of the receiver (E),
e) comparing the voltage differences existing between the third and fourth ports (A3, A4) of the receiver (E) to a third threshold value (SW3), wherein a first logical value is allocated to voltage differences above this third threshold value (SW3) and a second logical value is allocated to voltage differences below this third threshold value (SW3), which second logical value is inverted with respect to the first logical value,
f) comparing the amount of the sensed first common-mode voltage swing to a first threshold value (SW1), and increasing the differential transmission level if the amount of the first common-mode voltage swing is greater than the first threshold value (SW1),
g) comparing the amount of the sensed second common-mode voltage swing to a second threshold value (SW2), and increasing the third threshold value (SW3) if the amount of the second common-mode voltage swing is greater than the second threshold value (SW2) and
h) transmitting a data element from the transmitter (S) to the receiver (E) that depends on the result of the comparison of the amount of the sensed first common-mode voltage swing to the first threshold value (SW1), and increasing the third threshold value (SW3) if the amount of the first common-mode voltage swing is greater than the first threshold value (SW1).

4. Method for transmitting data (d) from a transmitter (S) to a receiver (E) via a two-wire data bus (Z) of a vehicle, using digital voltage signals, under the influence of common-mode interferences acting on the two-wire data bus (Z),
- wherein the two-wire data bus (Z) comprises a first data bus line (d1) and a second data bus line (d2),
- wherein the transmitter (S) comprises a first port (A1) connected to the first data bus line (d1) and a second port (A2) connected to the second data bus line (A2), as well as a reference potential port (BP1), and
- wherein the receiver (E) comprises a third port (A3) connected to the first data bus line (d1) and a fourth port (A4) connected to the second data bus line (d2), as well as a second reference potential port (BP2),
the method comprising the following steps:
a) sensing a second common-mode voltage swing at the third and fourth ports (A3, A4) of the receiver (E) with respect to the second reference potential port (BP2) and forming a second common-mode signal (k2),
b) transmitting data (d) by the transmitter (S) to the receiver (E) via the two-wire data bus (Z) by applying a digital voltage signal between the first and second ports (A1, A2) of the transmitter (S) for generating voltage differences between the same,
c) receiving the data by the receiver (E) by means of sensing the voltage differences between the third port (A3) and the fourth port (A4) of the receiver (E),
d) comparing the voltage differences existing between the third and fourth ports (A3, A4) of the receiver (E) to a lower reception threshold (SW4), wherein, in case of voltage differences below this lower reception threshold (SW4), an output (O) of a sub-device (CMP3) performing the comparison assumes a first level to which a first logical value is allocated, and to an upper reception threshold (SW5), wherein, in case of voltage differences above this upper reception threshold (SW5), a or the output (O) of a or the sub-device (CMP3) performing the comparison assumes a second level to which a second logical value is allocated that is complementary to the first logical value,
e) comparing the amount of the sensed second common-mode voltage swing to a second threshold value (SW2), and increasing the upper reception threshold (SW5), as well as decreasing the lower reception threshold (SW4) if the amount of the second common-mode voltage swing is greater than the second threshold value (SW2).

5. Method for transmitting data (d) from a transmitter (S) to a receiver (E) via a two-wire data bus (Z) of a vehicle, using digital voltage signals, under the influence of common-mode interferences acting on the two-wire data bus (Z),
- wherein the two-wire data bus (Z) comprises a first data bus line (d1) and a second data bus line (d2),
- wherein the transmitter (S) comprises a first port (A1) connected to the first data bus line (d1) and a second port (A2) connected to the second data bus line (A2), as well as a reference potential port (BP1),
- wherein the transmitter (S) comprises a first driver (D1) for the first port (A1) and a second driver (D2) for the second port (A1), and
- wherein the receiver (E) comprises a third port (A3) connected to the first data bus line (d1) and a fourth port (A4) connected to the second data bus line (d2), as well as a second reference potential port (BP2),
the method comprising the following steps:
a) sensing a first common-mode voltage swing at the first and second ports (A1, A2) of the transmitter (S) with respect to the first reference potential port (BP1) and forming a first common-mode signal (k1),
b) sensing a second common-mode voltage swing at the third and fourth ports (A3, A4) of the receiver (E) with respect to the second reference potential port (BP2) and forming a second common-mode signal (k2),
c) transmitting data (d) by the transmitter (S) to the receiver (E) via the two-wire data bus (Z) by applying a digital voltage signal between the first and second ports (A1, A2) of the transmitter (S) with a differential transmission level,
i) wherein the first driver (D1) drives the first data line (d1) with a first (O1) and a first voltage level (P1),
ii) wherein the second driver (D2) drives the second data line (d2) with a second offset (O2) and a second voltage level (P2), and
iii) wherein the differential transmission level is the difference from the first voltage level (P1) and the second voltage level (P2),
d) receiving the data by the receiver (E) by means of sensing the voltage differences between the third port (A3) and the fourth port (A4) of the receiver (E),
e) comparing the voltage differences existing between the third and fourth ports (A3, A4) of the receiver (E) to a lower reception threshold (SW4), wherein, in case of voltage differences below this lower reception threshold (SW4), an output (O) of a sub-device (CMP3) performing the comparison assumes a first level to which a first logical value is allocated, and to an upper reception threshold (SW5), wherein, in case of voltage differences above this upper reception threshold (SW5), a or the output (O) of a or the sub-device (CMP3) performing the comparison assumes a second level to which a second logical value is allocated that is complementary to the first logical value,
f) comparing the amount of the sensed first common-mode voltage swing to a first threshold value (SW1), and increasing the differential transmission level if the amount of the first common-mode voltage swing is greater than the first threshold value (SW1),
g) comparing the amount of the sensed second common-mode voltage swing to a second threshold value (SW2), and increasing the upper reception threshold (SW5), as well as decreasing the lower reception threshold (SW4) if the amount of the second common-mode voltage swing is greater than the second threshold value (SW2) and
h) transmitting a data element from the transmitter (S) to the receiver (E) that depends on the result of the comparison of the amount of the sensed first common-mode voltage swing to the first threshold value (SW1), and increasing the upper reception threshold (SW5), as well as decreasing the lower reception threshold (SW4) if the amount of the first common-mode voltage swing is greater than the first threshold value (SW1).

## Revendications

1. Procédé destiné à la transmission de données (d) au moyen de signaux de tension numériques par l'intermédiaire d'un bus de données à deux fils (Z) provenant d'un véhicule, depuis un émetteur (S) vers un récepteur (E) sous l'effet de bruitages en mode commun qui agissent sur le bus de données à deux fils (Z),
- selon lequel le bus de données à deux fils (Z) présente une première ligne de bus de données (d1) et une deuxième ligne de bus de données (d2),
- selon lequel l'émetteur (S) présente une première connexion (A1) connectée à la première ligne de bus de données (d1), ainsi qu'une deuxième connexion (A2) connectée à la deuxième ligne de bus de données (d2), ainsi qu'une première connexion du potentiel de référence (BP1),
- selon lequel l'émetteur (S) présente un premier circuit d'attaque (D1) pour la première connexion (A1) et un deuxième circuit d'attaque (D2) pour la deuxième connexion (A1), et
- selon lequel le récepteur (E) présente une troisième connexion (A3) connectée à la première ligne de bus de données (d1), ainsi qu'une quatrième connexion (A4) connectée à la deuxième ligne de bus de données (d2) et une deuxième connexion du potentiel de référence (BP2),
lequel procédé présente les phases suivantes :
a) la saisie d'une première excursion de tension en mode commun au niveau de la première connexion et de la deuxième connexion (A1, A2) de l'émetteur (S) par rapport à la première connexion du potentiel de référence (BP1) et la formation d'un premier signal de mode commun (k1),
b) l'émission de données (d) par l'émetteur (S) par l'intermédiaire du bus de données à deux fils (Z) vers le récepteur (E) par l'application d'un signal de tension numérique entre la première connexion et la deuxième connexion (A1, A2) de l'émetteur (S), avec un niveau de transmission différentiel,
i) selon lequel le premier circuit d'attaque (D1) alimente la première ligne de données (d1) avec un premier décalage (O1) et un premier niveau de tension (P1),
ii) selon lequel le deuxième circuit d'attaque (D2) alimente la deuxième ligne de données (d2) avec un deuxième décalage (O2) et un deuxième niveau de tension (P2), et
iii) selon lequel le niveau de transmission différentiel est la différence issue du premier niveau de tension (P1) et du deuxième niveau de tension (P2),
c) la réception des données par le récepteur (E) au moyen de la saisie des différences de tension entre la troisième connexion (A3) et la quatrième connexion (A4) du récepteur (E), et
d) la comparaison du montant de la première excursion de tension en mode commun saisie avec une première valeur de seuil (SW1),
**caractérisé par**
e) l'élévation du niveau de transmission différentiel quand le montant de la première excursion de tension en mode commun est supérieur à la première valeur de seuil (SW1).

2. Procédé destiné à la transmission de données (d) au moyen de signaux de tension numériques par l'intermédiaire d'un bus de données à deux fils (Z) provenant d'un véhicule, depuis un émetteur (S) vers un récepteur (E) sous l'effet de bruitages en mode commun qui agissent sur le bus de données à deux fils (Z),
- selon lequel le bus de données à deux fils (Z) ) présente une première ligne de bus de données (d1) et une deuxième ligne de bus de données (d2),
- selon lequel l'émetteur (S) présente une première connexion (A1) connectée à la première ligne de bus de données (d1), ainsi qu'une deuxième connexion (A2) ) connectée à la deuxième ligne de bus de données (d2), ainsi qu'une première connexion du potentiel de référence (BP1), et
- selon lequel le récepteur (E) présente une troisième connexion (A3) connectée à la première ligne de ) bus de données (d1), ainsi qu'une quatrième connexion (A4) connectée à la deuxième ligne de bus de données (d2), ainsi qu'une deuxième connexion du potentiel de référence (BP2), lequel procédé présente les phases suivantes :
a) la saisie d'une deuxième excursion de tension en ) mode commun au niveau de la troisième et de la quatrième connexion (A3, A4) du récepteur (E) par rapport à la deuxième connexion du potentiel de référence (BP2) et la formation d'un deuxième signal de mode commun (k2),
b) l'émission de données (d) par l'émetteur (S) par ) l'intermédiaire du bus de données à deux fils (Z) vers le récepteur (E) par l'application d'un signal de tension numérique entre la première connexion et la deuxième connexion (A1, A2) de l'émetteur (S) en vue de la génération de différences de tension entre celles-ci,
c) la réception des données par le récepteur (E) au moyen de la saisie des différences de tension entre la troisième connexion (A3) et la quatrième connexion (A4) du récepteur (E), et
d) la comparaison des différences de tension existantes entre la troisième connexion et la quatrième connexion (A3, A4) du récepteur (E) avec une troisième valeur de seuil (SW3), une première valeur logique étant associée à des différences de tension situées au-dessus de cette troisième valeur de seuil (SW3), et une deuxième valeur logique, laquelle est inversée par rapport à la première valeur logique, étant associée à des différences de tension situées au-dessous de cette troisième valeur de seuil (SW3),
**caractérisé par**
e) la comparaison du montant de la deuxième excursion de tension en mode commun saisie avec une deuxième valeur de seuil (SW2), et
f) l'élévation de la troisième valeur de seuil (SW3) quand le montant de la deuxième excursion de tension en mode commun est supérieur à la deuxième valeur de seuil (SW2) .

3. Procédé destiné à la transmission de données (d) au moyen de signaux de tension numériques par l'intermédiaire d'un bus de données à deux fils (Z) provenant d'un véhicule, depuis un émetteur (S) vers un récepteur (E), sous l'effet de bruitages en mode commun qui agissent sur le bus de données à deux fils (Z),
- selon lequel le bus de données à deux fils (Z) présente une première ligne de bus de données (d1) et une deuxième ligne de bus de données (d2),
- selon lequel l'émetteur (S) présente une première connexion (A1) connectée à la première ligne de bus de données (d1), ainsi qu'une deuxième connexion (A2) connectée à la deuxième ligne de bus de données (d2), ainsi qu'une première connexion du potentiel de référence (BP1),
- selon lequel l'émetteur (S) présente un premier circuit d'attaque (D1) pour la première connexion (A1) et un deuxième circuit d'attaque (D2) pour la deuxième connexion (A2), et
- selon lequel le récepteur (E) présente une troisième connexion (A3) connectée à la première ligne de bus de données (d1), ainsi qu'une quatrième connexion (A4) connectée à la deuxième ligne de bus de données (d2), ainsi qu'une deuxième connexion du potentiel de référence (BP2), lequel procédé présente les phases suivantes :
a) la saisie d'une première excursion de tension en mode commun au niveau de la première connexion et de la deuxième connexion (A1, A2) de l'émetteur (S) par rapport à la première connexion du potentiel de référence (BP1) et la formation d'un premier signal de mode commun (k1),
b) la saisie d'une deuxième excursion de tension en mode commun au niveau de la troisième connexion et de la quatrième connexion (A3, A4) du récepteur (E) par rapport à la deuxième connexion du potentiel de référence (BP2) et la formation d'un deuxième signal de mode commun (k2),
c) l'émission de données (d) par l'émetteur (S) par l'intermédiaire du bus de données à deux fils (Z) vers le récepteur (E) par l'application d'un signal de tension numérique entre la première connexion et la deuxième connexion (A1, A2) de l'émetteur (S) avec un niveau de transmission différentiel,
i) selon lequel le premier circuit d'attaque (D1) alimente la première ligne de données (d1) avec un premier décalage (O1) et un premier niveau de tension (P1),
ii) selon lequel le deuxième circuit d'attaque (D2) alimente la deuxième ligne de données (d2) avec un deuxième décalage (O2) et un deuxième niveau de tension (P2) et
iii) selon lequel le niveau de transmission différentiel est la différence issue du premier niveau de tension (P1) et du deuxième niveau de tension (P2),
d) la réception des données par le récepteur (E) au moyen de la saisie des différences de tension entre la troisième connexion (A3) et la quatrième connexion (A4) du récepteur (E),
e) la comparaison des différences de tension existantes entre la troisième connexion et la quatrième connexion (A3, A4) du récepteur (E) avec une troisième valeur de seuil (SW3), une première valeur logique étant associée à des différences de tension situées au-dessus de cette troisième valeur de seuil (SW3) et une deuxième valeur logique, laquelle est inversée par rapport à la première valeur logique, étant associée à des différences de tension situées au-dessous de cette troisième valeur de seuil (SW3),
f) la comparaison du montant de la première excursion de tension en mode commun saisie avec une première valeur de seuil (SW1) et l'élévation du niveau de transmission différentiel quand le montant de la première excursion de tension en mode commun est supérieur à la première valeur de seuil (SW1),
g) la comparaison du montant de la deuxième excursion de tension en mode commun saisie avec une deuxième valeur de seuil (SW2) et l'élévation de la troisième valeur de seuil (SW3) quand le montant de la deuxième excursion de tension en mode commun est supérieur à la deuxième valeur de seuil (SW2), et
h) la transmission d'une date depuis l'émetteur (S) jusqu'au récepteur (E), laquelle dépend du résultat de la comparaison du montant de la première excursion de tension en mode commun saisie avec la première valeur de seuil (SW1), ainsi que l'élévation de la troisième valeur de seuil (SW3) quand le montant de la première excursion de tension en mode commun est supérieur à la première valeur de seuil (SW1).

4. Procédé destiné à la transmission de données (d) au moyen de signaux de tension numériques par l'intermédiaire d'un bus de données à deux fils (Z) provenant d'un véhicule, depuis un émetteur (S) vers un récepteur (E), sous l'effet de bruitages en mode commun qui agissent sur le bus de données à deux fils (Z),
- selon lequel le bus de données à deux fils (Z) présente une première ligne de bus de données (d1) et une deuxième ligne de bus de données (d2),
- selon lequel l'émetteur (S) présente une première connexion (A1) connectée à la première ligne de bus de données (d1), ainsi qu'une deuxième connexion (A2) connectée à la deuxième ligne de bus de données (d2), ainsi qu'une première connexion du potentiel de référence (BP1), et
- selon lequel le récepteur (E) présente une troisième connexion (A3) connectée à la première ligne de bus de données (d1), ainsi qu'une quatrième connexion (A4) connectée à la deuxième ligne de bus de données (d2) et une deuxième connexion du potentiel de référence (BP2), lequel procédé présente les phases suivantes :
a) la saisie d'une deuxième excursion de tension en mode commun au niveau de la troisième connexion et de la quatrième connexion (A3, A4) du récepteur (E) par rapport à la deuxième connexion du potentiel de référence (BP2) et la formation d'un deuxième signal de mode commun (k2),
b) l'émission de données (d) par l'émetteur (S) par l'intermédiaire du bus de données à deux fils (Z) vers le récepteur (E) par l'application d'un signal de tension numérique entre la première connexion et la deuxième connexion (A1, A2) de l'émetteur (S) en vue de la génération de différences de tension entre celles-ci,
c) la réception des données par le récepteur (E) au moyen de la saisie des différences de tension entre la troisième connexion (A3) et la quatrième connexion (A4) du récepteur (E),
d) la comparaison des différences de tension existantes entre la troisième connexion et la quatrième connexion (A3, A4) du récepteur (E) avec un seuil de réception (SW4) inférieur, une sortie (O) provenant d'un dispositif partiel (CMP3) effectuant la comparaison adoptant, en cas de différences de tension situées au-dessous de ce seuil de réception (SW4) inférieur, un premier niveau auquel est associée une première valeur logique, et avec un seuil de réception (SW5) supérieur, une sortie, respectivement la sortie (O) d'un dispositif partiel, respectivement du dispositif partiel (CMP3) effectuant la comparaison adoptant, en cas de différences de tension situées au-dessus de ce seuil de réception (SW5) supérieur, un deuxième niveau auquel est associée une deuxième valeur logique, laquelle est complémentaire vis-à-vis de la première valeur logique,
e) la comparaison du montant de la deuxième excursion de tension en mode commun saisie avec une deuxième valeur de seuil (SW2) et l'élévation du seuil de réception (SW5) supérieur, ainsi que l'abaissement du seuil de réception (SW4) inférieur quand le montant de la deuxième excursion de tension en mode commun est supérieur à la deuxième valeur de seuil (SW2).

5. Procédé destiné à la transmission de données (d) au moyen de signaux de tension numériques par l'intermédiaire d'un bus de données à deux fils (Z) provenant d'un véhicule, depuis un émetteur (S) vers un récepteur (E), sous l'effet de bruitages en mode commun qui agissent sur le bus de données à deux fils (Z),
- selon lequel le bus de données à deux fils (Z) présente une première ligne de bus de données (d1) et une deuxième ligne de bus de données (d2),
- selon lequel l'émetteur (S) présente une première connexion (A1) connectée à la première ligne de bus de données (d1), ainsi qu'une deuxième connexion (A2) connectée à la deuxième ligne de bus de données (d2), ainsi qu'une première connexion du potentiel de référence (BP1),
- selon lequel l'émetteur (S) présente un premier circuit d'attaque (D1) pour la première connexion (A1) et un deuxième circuit d'attaque (D2) pour la deuxième connexion (A2), et
- selon lequel le récepteur (E) présente une troisième connexion (A3) connectée à la première ligne de bus de données (d1), ainsi qu'une quatrième connexion (A4) connectée à la deuxième ligne de bus de données (d2), ainsi qu'une deuxième connexion du potentiel de référence (BP2), lequel procédé présente les phases suivantes :
a) la saisie d'une première excursion de tension en mode commun au niveau de la première connexion et de la deuxième connexion (A1, A2) de l'émetteur (S) par rapport à la première connexion du potentiel de référence (BP1) et la formation d'un premier signal de mode commun (k1),
b) la saisie d'une deuxième excursion de tension en mode commun au niveau de la troisième connexion et de la quatrième connexion (A3, A4) du récepteur (E) par rapport à la deuxième connexion du potentiel de référence (BP2) et la formation d'un deuxième signal de mode commun (k2),
c) l'émission de données (d) par l'émetteur (S) par l'intermédiaire du bus de données à deux fils (Z) vers le récepteur (E) par l'application d'un signal de tension numérique entre la première connexion et la deuxième connexion (A1, A2) de l'émetteur (S) avec un niveau de transmission différentiel,
i) selon lequel le premier circuit d'attaque (D1) alimente la première ligne de données (d1) avec un premier décalage (O1) et un premier niveau de tension (P1),
ii) selon lequel le deuxième circuit d'attaque (D2) alimente la deuxième ligne de données (d2) avec un deuxième décalage (O2) et un deuxième niveau de tension (P2), et
iii) selon lequel le niveau de transmission différentiel est la différence issue du premier niveau de tension (P1) et du deuxième niveau de tension (P2),
d) la réception des données par le récepteur (E) au moyen de la saisie des différences de tension entre la troisième connexion (A3) et la quatrième connexion (A4) du récepteur (E),
e) la comparaison des différences de tension existantes entre la troisième connexion et la quatrième connexion (A3, A4) du récepteur (E) avec un seuil de réception (SW4) inférieur, une sortie (O) provenant d'un dispositif partiel (CMP3) effectuant la comparaison adoptant, en cas de différences de tension situées au-dessous de ce seuil de réception (SW4) inférieur, un premier niveau auquel est associée une première valeur logique, et avec un seuil de réception (SW5) supérieur, une sortie, respectivement la sortie (O) d'un dispositif partiel, respectivement du dispositif partiel (CMP3) effectuant la comparaison adoptant, en cas de différences de tension situées au-dessus de ce seuil de réception (SW5) supérieur, un deuxième niveau auquel est associée une deuxième valeur logique, laquelle est complémentaire vis-à-vis de la première valeur logique,
f) la comparaison du montant de la première excursion de tension en mode commun saisie avec une première valeur de seuil (SW1) et l'élévation du niveau de transmission différentiel quand le montant de la première excursion de tension en mode commun est supérieur à la première valeur de seuil (SW1),
g) la comparaison du montant de la deuxième excursion de tension en mode commun saisie avec une deuxième valeur de seuil (SW2) et l'élévation du seuil de réception (SW5) supérieur, ainsi que l'abaissement du seuil de réception (SW4) inférieur quand le montant de la deuxième excursion de tension en mode commun est supérieur à la deuxième valeur de seuil (SW2), et
h) la transmission d'une date depuis l'émetteur (S) jusqu'au récepteur (E), laquelle dépend du résultat de la comparaison du montant de la première excursion de tension en mode commun saisie avec la première valeur de seuil (SW1), et l'élévation du seuil de réception (SW5) supérieur, ainsi que l'abaissement du seuil de réception (SW4) inférieur, quand le montant de la première excursion de tension en mode commun est supérieur à la première valeur de seuil (SW1).
